# EUROPEAN PATENT APPLICATION

(11) **EP 4 369 365 A1**
(43) Date of publication of application: **15.05.2024**
(21) Application number: 23209562.0
(22) Date of filing: 13.11.2023
(51) Int. Cl.: H01F 27/28, H01F 27/34, H01F 27/40, H02M 1/42, H02M 3/00, H02M 3/158, H02M 3/335

(54) **PLANAR TRANSFORMER**

(30) Priority: 14.11.2022 US 202263425014 P
(71) Applicant: Delta Electronics Inc., Taoyuan City 320023 (TW)
(72) Inventor: CHIU, Yi-Hsun, 320023 Taoyuan City (TW); CHANG, Yi-Sheng, 320023 Taoyuan City (TW); YANG, Chun-Yu, 320023 Taoyuan City (TW); TSAI, Meng-Chi, 320023 Taoyuan City (TW)
(74) Representative: 2K Patentanwälte Blasberg Kewitz & Reichel

(57) **Abstract**

A planar transformer (2A) is configured on a multi-layer circuit board (CB 1) of a resonant converter (100). The planar transformer (2A) includes multiple layers of primary-side traces (Tp1), multiple layers of secondary-side traces (Ts1), and an iron core (C1). The primary-side traces (Tp1) serve as a primary-side coil (22A) of the transformer to generate a first direction magnetic flux (F_D1) when the resonant converter (100) operates. The secondary-side traces (Ts1) serve as a secondary-side coil (24A) of the transformer to generate a second direction magnetic flux (F_D2) when the resonant converter (100) operates. The primary-side traces (Tp1) and the secondary-side traces (Ts1) surround a first core pillar (C12) and the second core pillar (C14), and the primary-side traces (Tp1) and the secondary-side traces (Ts1) are configured in a specific stacked structure on the multi-layer circuit board (CB1), so that a magnetomotive force (MMF) of the planar transformer (2A) can maintain balance during the operation of the resonant converter (100).

## Description

### BACKGROUND

### Technical Field

The present disclosure relates to a planar transformer, and more particularly to a planar transformer with a specific stacked structure.

### Description of Related Art

The statements in this section merely provide background information related to the present disclosure and do not necessarily constitute prior art.

With the rapid development of the information industry, power supplies have played an indispensable role. The input voltage of information and household appliances is divided into AC voltage and DC voltage, and power supplies can generally be divided into two levels. In general, the front stage is usually an AC-to-DC converter, a power factor corrector or a DC-to-DC converter, and the rear stage is usually a resonant converter. The resonant converter is a DC-to-DC power converter, and it has a primary-side switch that turns on at zero voltage and a secondary-side rectification switch that turns off at zero current. Therefore, it has the advantages of high power and high conversion efficiency than other converters. Furthermore, using a rectification switch on the secondary side makes it easier to achieve high efficiency and high power density.

In particular, resonant converters usually include inductive components such as resonant inductors and transformers, and these inductive components are usually composed of coils, bobbins, and iron cores. Since the coil must be formed by winding copper wire on the winding frame for more than dozens of turns, and then the iron core is used to set the winding to form a closed magnetic circuit, resonant inductors and transformers usually have the fatal disadvantage of being bulky. Therefore, the size of the resonant converter cannot be effectively reduced, resulting in the problem of bulky power supply and poor power density.

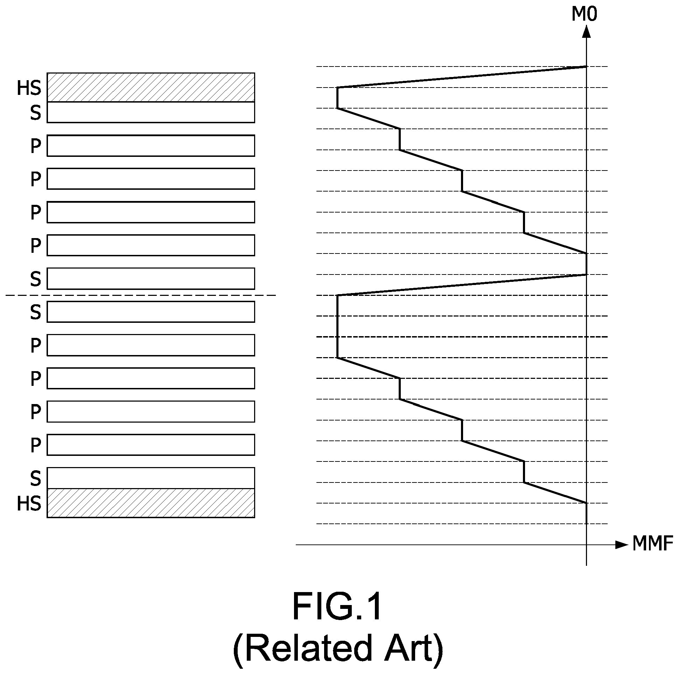

Please refer to FIG. 1, which shows a conventional magnetomotive force curve diagram of a transformer used in a conventional resonant converter. In FIG. 1, the structure arranged from top to bottom on the left side of the figure includes the primary-side coil P, the secondary-side coil S, and the heat sink HS, and the right side of the figure is the magnetomotive force curve formed corresponding to the stacked structure on the left side of the figure. Since the transformer coil arrangement structure on the left side of the figure is not specially designed, the magnetomotive force MMF on the right side of the figure will be biased to one side (from the magnetic flux origin M0). This will increase the AC impedance on the coil and cause the line loss to increase, and it will cause the heat generated by the transformer to be excessively concentrated, which is not conducive to heat dissipation.

Therefore, how to design a planar transformer to replace the traditional transformer in the resonant converter to greatly reduce the size of the resonant converter and use a specific stacked structure to achieve magnetomotive force balance has become a critical topic in this field.

### SUMMARY

In order to solve the above-mentioned problems, the present disclosure provides a planar transformer. The planar transformer is arranged on a circuit board of a resonant converter, and the resonant converter includes a primary-side circuit and a secondary-side circuit. The planar transformer includes a plurality of primary-side traces, a plurality of secondary-side traces, and an iron core. The plurality of primary-side traces respectively form on a plurality of primary-side layers on the circuit board; the primary-side traces serve as a primary-side coil coupled to the primary-side circuit, so that when the primary-side circuit operates, the primary-side traces respectively generate a first direction magnetic flux. The plurality of secondary-side traces respectively form on a plurality of secondary-side layers on the circuit board; the secondary-side traces serve as a secondary-side coil coupled to the secondary-side circuit, so that when the secondary-side circuit operates, the secondary-side traces respectively generate a second direction magnetic flux. The iron core includes a first core pillar and a second core pillar. The first core pillar and the second core pillar respectively penetrate a first through hole and a second through hole of the circuit board, and the primary-side traces and the secondary-side traces surrounding the first core pillar and the second core pillar. The primary-side traces and the secondary-side traces are configured in a specific stacked structure to maintain the first direction magnetic flux and the second direction magnetic flux within a specific range formed by a magnetic flux origin and a first predetermined offset and a second predetermined offset, so that a magnetomotive force of the planar transformer remains balanced.

The main purpose and effect of the present disclosure is that since the primary-side trace and the secondary-side trace are configured as the specific stacked structure, the first direction magnetic flux generated by primary-side traces and the second direction magnetic generated by secondary-side traces can be maintained within a specific range formed by the magnetic flux origin and the first predetermined offset and the second predetermined offset, so that the magnetomotive force of the planar transformer maintains balanced.

It is to be understood that both the foregoing general description and the following detailed description are exemplary, and are intended to provide further explanation of the present disclosure as claimed. Other advantages and features of the present disclosure will be apparent from the following description, drawings, and claims.

### BRIEF DESCRIPTION OF DRAWINGS

The present disclosure can be more fully understood by reading the following detailed description of the embodiment, with reference made to the accompanying drawing as follows:
FIG. 1 is a conventional magnetomotive force curve diagram of a transformer used in a conventional resonant converter.
FIG. 2 is a circuit block diagram of a resonant converter of the present disclosure.
FIG. 3A is an exploded view of the three-dimensional circuit structure of the resonant converter of the present disclosure.
FIG. 3B is an assembly view of the three-dimensional circuit structure of the resonant converter of the present disclosure.
FIG. 4A to FIG. 4L are schematic diagrams of coil traces of planar magnetic components in each layer of a circuit board according to the present disclosure.
FIG. 5A is a stacked structure of the planar transformer on each layer of the circuit board according to the first embodiment of the present disclosure, and a magnetomotive force curve diagram when the planar transformer is operated on first traces.
FIG. 5B is a stacked structure of the planar transformer on each layer of the circuit board according to the first embodiment of the present disclosure, and the magnetomotive force curve diagram when the planar transformer is operated on second traces.
FIG. 6A is a stacked structure of the planar transformer on each layer of the circuit board according to the second embodiment of the present disclosure, and a magnetomotive force curve diagram when the planar transformer is operated on first traces.
FIG. 6B is a stacked structure of the planar transformer on each layer of the circuit board according to the second embodiment of the present disclosure, and the magnetomotive force curve diagram when the planar transformer is operated on second traces.
FIG. 7A to FIG. 7H are stacked structures and magnetomotive force curves on each layer of the circuit board of the planar first transformer according to the third to tenth embodiments of the present disclosure.
FIG. 8 is a schematic structural diagram of the inductor core and the first iron core with the first through hole, the second through hole, and the third through hole of the present disclosure.

### DETAILED DESCRIPTION

Reference will now be made to the drawing figures to describe the present disclosure in detail. It will be understood that the drawing figures and exemplified embodiments of present disclosure are not limited to the details thereof.

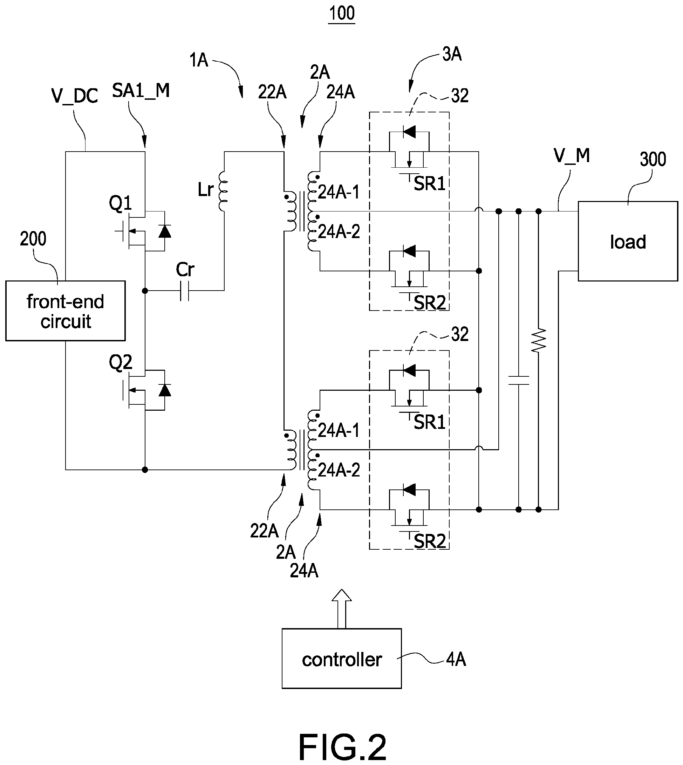

Please refer to FIG. 2, which shows a circuit block diagram of a resonant converter of the present disclosure, and also refer to FIG. 1. The resonant converter 100 is be coupled to a front-end circuit 200 and a load 300, and the front-end circuit 200 may be a DC power supply such as an AC-to-DC converter, a power factor corrector, a DC power source, or so on. The resonant converter 100 includes a primary-side circuit 1A, at least one transformer 2A (two transformers are shown as an example), at least one secondary-side circuit 3A (two secondary-side circuits are shown as an example), and a controller 4A. The transformer 2A includes a primary-side coil 22A and a secondary-side coil 24A. Taking FIG. 1 as an example, the primary-side circuit 1A is a half-bridge architecture, including one switch bridge arm SA1_M and one resonant tank (i.e., a resonant inductor Lr and a resonant capacitor Cr), and the switch bridge arm SA1_M includes two power switches Q1,Q2 connected in series. The secondary-side circuit 3A includes two rectification circuits 32, and each rectification circuit 32 includes two rectification switches SR1,SR2. The secondary-side coil 24A of the transformer 2A includes a first winding 24A-1 and a second winding 24A-2, and the first winding 24A-1 and the second winding 24A-2 are center-tapped windings. Therefore, the resonant converter 100 can control the turning on/turning off of the rectification switches SR1,SR2 by the controller 4A, so that the first winding 24A-1 and the second winding 24A-2 are respectively coupled to the primary-side coil 22A.

In general, the controller 4A controls the switch bridge arm SA1_M and the rectification switches SR1,SR2 of the rectification circuit 32 to operate the resonant tank and the transformer 2A storing energy and releasing energy so as to convert the DC power source V_DC received by the resonant converter 100 into a main power source V_M. Incidentally, the circuit structures of the primary-side circuit 1A and the secondary-side circuit 3A are only illustrative examples. As long as the primary-side circuit 1A (such as, but not limited to, a full-bridge structure, two resonant tanks, etc.) and the secondary-side circuit 3A (such as, but not limited to, a half-bridge rectification circuit, one rectification circuit, etc.) can form the structure of the resonant converter 100, should be included in the scope of this embodiment. In one embodiment, the number of the transformers 2A is not limited to two as shown in FIG. 1, i.e., the number of the transformer 2A may be one or more than one. When the number of the transformer 2A is one, the resonant converter 100 includes one primary-side coil 22A, one first winding 24A-1, and one second winding 24A-2, and so on.

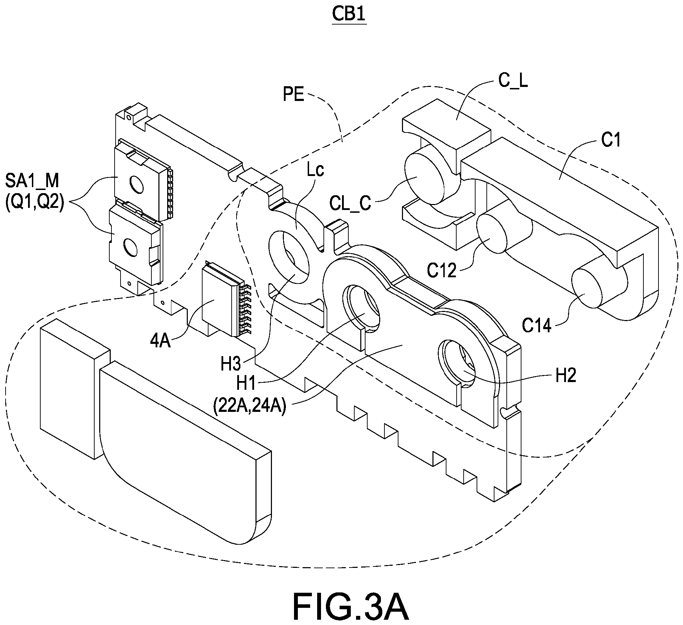

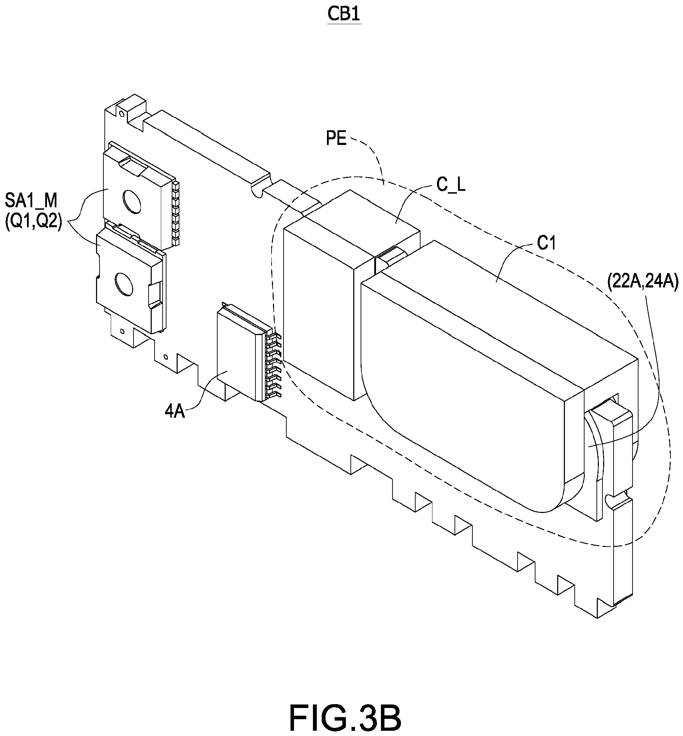

Please refer to FIG. 3A, which shows an exploded view of the three-dimensional circuit structure of the resonant converter of the present disclosure; please refer to FIG. 3B, which shows an assembly view of the three-dimensional circuit structure of the resonant converter of the present disclosure, and also refer to FIG. 2. The circuit components of the resonant converter 100 are configured on a circuit board CB1, and the two switch bridge arms SA1_M and the controller 4A are arranged in positions as shown in FIG. 2. In particular, the resonant inductor Lr and the (at least one) transformer 2A form a planar magnetic component PE. Specifically, an inductor coil Lc of the resonant inductor Lr and the primary-side coil 22A and the secondary-side coil 24A of the transformer 2A are all planar structures, which are formed on the circuit board CB 1. An iron core C1 is directly sleeved on the primary-side coil 22A and the secondary-side coil 24A of the circuit board CB1 to form the (at least one) transformer 2A, and an inductor iron core C_L is directly sleeved on an inductor coil Lc of the circuit board CB1 to form the resonant inductor Lr.

Therefore, the structure of the resonant converter 100 of the present disclosure mainly forms the inductor coil Lc of the resonant inductor Lr and the primary-side coil 22A and the secondary-side coil 24A of the transformer 2A on the circuit board CB1, so that the planar magnetic component PE can be planarized to significantly increase the space utilization of the resonant converter 100 and meet the requirement of the high power density. In addition, due to the small size of the planar magnetic component PE, the operating frequency of the resonant converter 100 can be significantly increased. Therefore, the power switches of the switch bridge arm SA1_M and the rectification circuit 32 can use third-generation semiconductor components such as the wide bandgap (WBG) as the main power switch, so that the resonant converter 100 has the advantages of higher efficiency, significantly reduced power switch size, lighter weight, and increased heat dissipation performance.

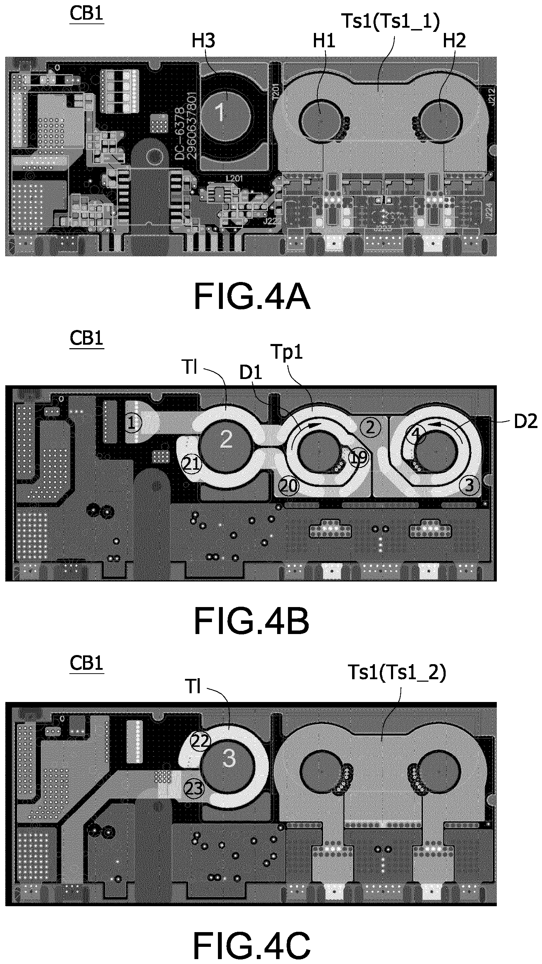

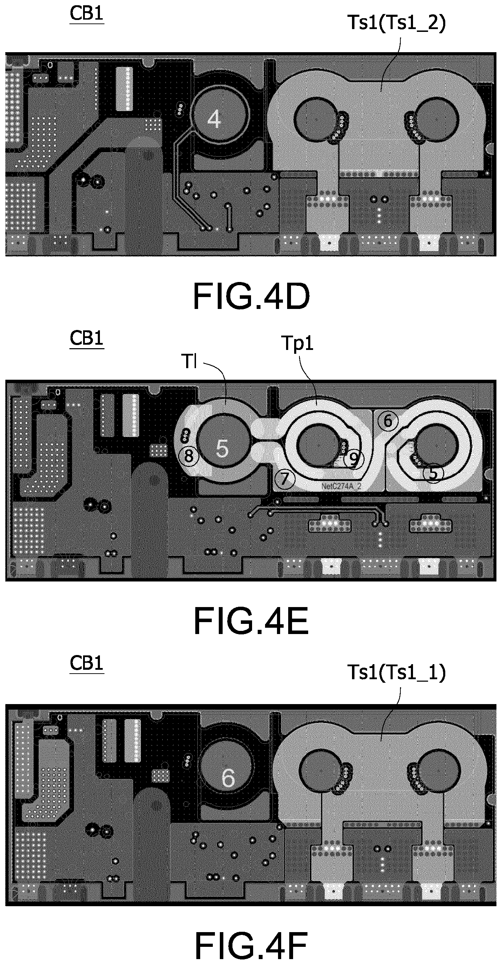

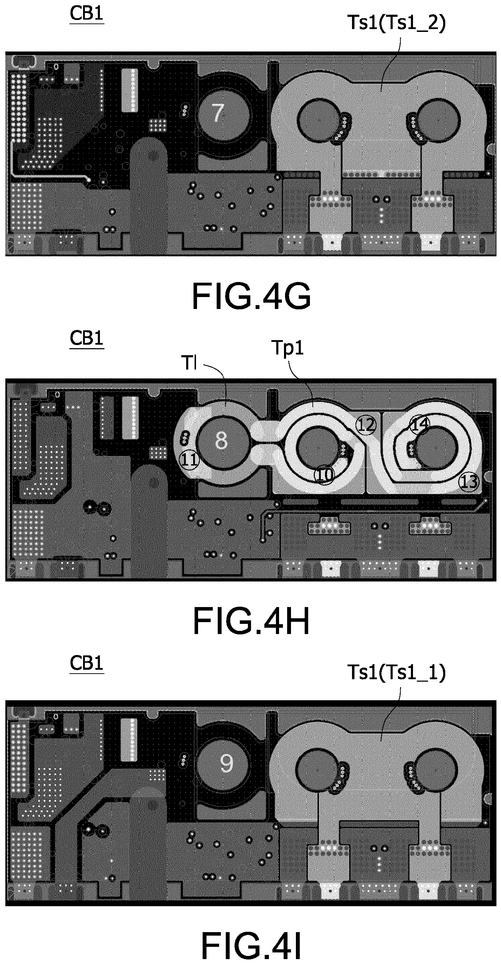

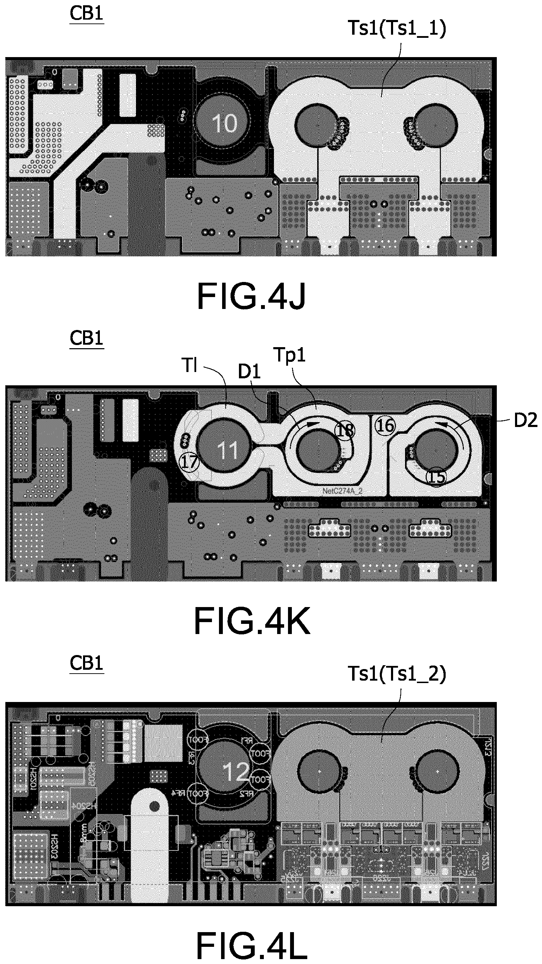

Please refer to FIG. 4A to FIG. 4L, which show are schematic diagrams of coil traces of planar magnetic components in each layer of a circuit board according to the present disclosure, and also refer to FIG. 2 to FIG. 3B. The circuit board CB1 is a multi-layer board (a 12-layer board is used as an example, but is not limited thereto), and FIG. 4A shows a top board, and FIG. 4L shows a bottom board. In particular, an inductor trace Tl serves as the inductor coil Lc, and primary-side traces Tp1 serve as the primary-side coil 22A. The inductor trace Tl and the primary-side trace Tp1 are respectively formed on layer boards of FIG. 4B, FIG. 4E, FIG. 4H, and FIG. 4K (i.e., referred to as primary-side layer boards). Secondary-side traces Ts1 serve as the secondary-side coil 24A, and are formed on layer boards of FIG. 4A, FIG. 4C, FIG. 4D, FIG. 4F, FIG. 4G, FIG. 4I, FIG. 4J, and FIG. 4L (i.e., referred to as secondary-side layer boards).

In FIG. 3A and FIG. 3B, the iron core C1 includes a first core pillar C12 and a second core pillar C14. The first core pillar C12 penetrates a first through hole H1 of the circuit board CB1, and the second core pillar C14 penetrates a second through hole H2 of the circuit board CB1. The primary-side traces Tp1 surround the first through hole H1 and the second through hole H2, and the secondary-side traces Ts1 also surround the first through hole H1 and the second through hole H2, so that after the iron core C1 is sleeved on the primary-side traces Tp1 and the secondary-side traces Ts1, closed magnetic paths can be formed in the transformer 2A. Similarly, the inductor iron core C_L includes a core pillar C_LC. The core pillar C_LC penetrates a third through hole H3 of the circuit board CB1. The inductor traces Tl surround the third through hole H3, so that after the inductor iron core C_L is sleeved on the inductor traces Tl, closed magnetic paths can be formed in the resonant inductor Lr. In particular, the material of the traces formed by each layer board may be copper foil, but it does not exclude the use of other metal foils that are easy to conduct electricity (such as, but not limited to, gold, silver, etc.).

Furthermore, the primary-side trace Tp1 surround the first through hole H1 and the second through hole H2 at least two turns respectively, and the path of the primary-side trace Tp1 includes a plurality of via holes (not shown). These via holes are filled with conductive materials, so that the primary-side traces Tp1 of the primary-side layer boards in FIG. 4B, FIG. 4E, FIG. 4H, and FIG. 4K can be electrically connected to each other through the via holes. Similarly, the secondary-side traces Ts1 shown in FIG. 4A, FIG. 4C, FIG. 4D, FIG. 4F, FIG. 4G, FIG. 4I, FIG. 4J, and FIG. 4L can form two first secondary-side coils 24A as shown in FIG. 2. It can be inferred similarly that depending on the circuit configuration of the resonant converter 100, the secondary-side traces Ts1 may form one or more than one secondary-side coils 24A. The number of the first secondary-side coils 24A may be added depending on the number of layers of the circuit board CB1 and the number of turns of the secondary-side traces Tp1, which will not be described again here. In addition, in FIG. 4A, FIG. 4C, FIG. 4D, FIG. 4F, FIG. 4G, FIG. 4I, FIG. 4J, and FIG. 4L, the secondary-side trace Ts1 and the first through hole H1 and the second through hole H2 form an m-shaped trace. Moreover, the current flowing through the secondary-side trace Ts1 can flow out from the center point of the m-shape trace to two terminals respectively, or flow from the two terminals of the m-shape trace to the center point according to the actions of the rectification switches SR1,SR2. The bottom of m-shape trace may include a plurality of via holes (not shown). Therefore, the secondary-side traces Ts1 of the secondary-side layer boards in FIG. 4A, FIG. 4C, FIG. 4D, FIG. 4F, FIG. 4G, FIG. 4I, FIG. 4J, and FIG. 4L can be electrically connected to each other through the via holes.

In particular, since the secondary-side coil 24A has a center-tapped winding structure, the secondary-side trace Ts1 includes first traces Ts1_1 in a plurality of layers (shown in FIG. 4A, FIG, 4F, FIG, 4, and FIG. 4I) and second traces Ts1_2 (shown in FIG. 4C, FIG. 4D, FIG. 4G, and FIG. 4L). In particular, the first traces Ts1_1 of the secondary-side layer boards in FIG. 4A, FIG. 4F, FIG. 4I, and FIG. 4J can be connected to each other through via holes (not shown) respectively to form two first coils 24A-1 (as shown in FIG. 2). The second traces Ts1_2 of the secondary-side layer boards in FIG. 4C, FIG. 4D, FIG. 4G, and FIG. 4L can be connected to each other through via holes (not shown) respectively to form two second coils 24A-2 (as shown in FIG. 2). Similarly, the secondary-side traces Ts1 shown in FIG. 4A, FIG. 4C, FIG. 4D, FIG. 4F, FIG. 4G, FIG. 4I, FIG. 4J, and FIG. 4L can form two secondary-side coils 24A as shown in FIG. 2. It can be inferred similarly that depending on the circuit configuration of the resonant converter 100, the secondary-side traces Ts1 may form one or more than one secondary-side coils 24A. The number of the first secondary-side coils 24A may be added depending on the number of layers of the circuit board CB1 and the number of turns of the secondary-side traces Ts1, which will not be described again here.

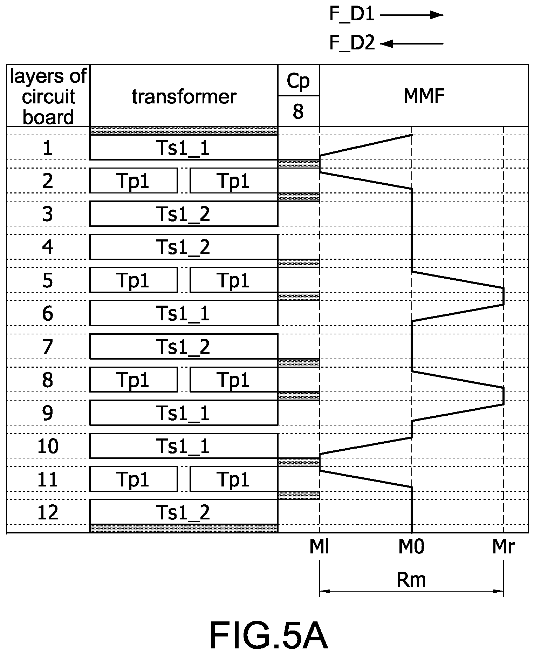

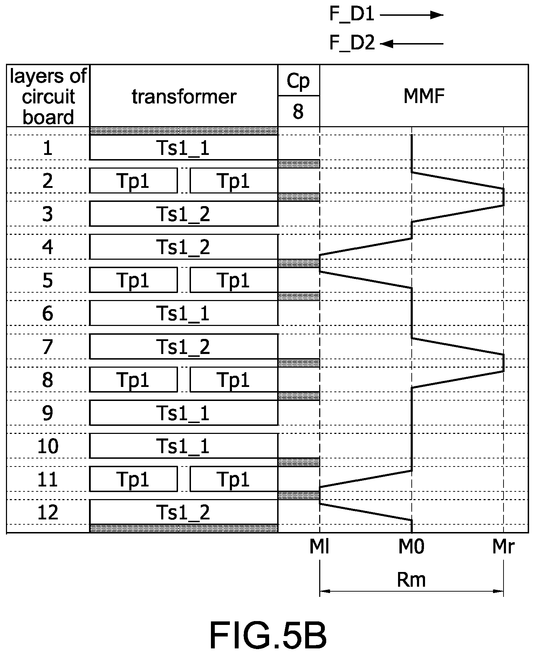

Please refer to FIG. 5A, which shows a stacked structure of the planar transformer on each layer of the circuit board according to the first embodiment of the present disclosure, and a magnetomotive force curve diagram when the planar transformer is operated on first traces; please refer to FIG. 5B, which shows a stacked structure of the planar transformer on each layer of the circuit board according to the first embodiment of the present disclosure, and the magnetomotive force curve diagram when the planar transformer is operated on second traces, and also refer to FIG. 2 to FIG. 4L. In FIG. 5A, the trace stack structure of FIG. 4A to FIG. 4L is used as a schematic example. In which, Ts1_1 represents the first trace, Ts1_2 represents the second trace, Tp represents the primary-side trace, and HS represents the heat sinks of the upper layer board and the lower layer board of the circuit board. In FIG. 5A, one cube represents that the layer board forms one turn of traces with the core hole as the center, and two cubes represents that the layer board forms two turns of traces with the core hole as the center. The spacing between each trace may be regarded as the thickness between two layer boards. Therefore, the primary-side trace Tp1 forms two turns of traces, and the first trace Ts1_1 and the second trace Ts1_2 form one turn of traces respectively (see FIG. 4A to FIG. 4L). On the other hand, in FIG. 5A, the horizontal axis of the magnetomotive force graph is the magnetomotive force (MMF), and the vertical axis is the position. The origin of the vertical axis is the magnetic flux origin M0, and the left side and the right side of the magnetic flux origin M0 include a first predetermined offset Ml and a second predetermined offset Mr respectively.

In particular, the first predetermined offset Ml and the second predetermined offset Mr are predetermined offsets acquired by calculating the parameters of the transformer 2A. When the transformer 2A actually operates, the actual offset will not be completely equal to the first predetermined offset Ml and the second predetermined offset Mr, however, the actual offset may still be within the error range of the first predetermined offset Ml and the second predetermined offset Mr. In order to clearly explain the characteristics of this embodiment, the subsequent magnetic flux curves in the present disclosure are illustrated under ideal conditions.

Please refer to FIG. 5A again, in the planar transformer 2A, the formation of the primary-side trace Tp1 causes the primary-side trace Tp1 to generate a first direction magnetic flux F_D1 (for example, but not limited to, it can be regarded that the direction of the magnetic flux shifts to the right) when the primary-side circuit 1A operates. The formation of the secondary-side trace Ts1 causes the secondary-side trace Ts1 to generate a second direction magnetic flux F_D2 (for example, but not limited to, it can be regarded that the direction of the magnetic flux shifts to the left) when the secondary-side circuit 3A operates. However, the direction of the magnetic flux mentioned above is only for illustration, since the polarity and current direction of the transformer 2A will determine the direction of the magnetic flux deviation. Therefore, the present disclosure does not limit the corresponding relationship between the left and right deviations of the primary-side trace Tp1 and the secondary-side trace Ts1, and the positions of the first predetermined offset Ml and the second predetermined offset Mr may be reversed according to the polarity and current direction of the transformer 2A.

The main purpose and effect of the present disclosure is that since the primary-side trace Tp1 and the secondary-side trace Ts1 are configured as, for example, but not limited to, the specific stacked structure of FIG. 5A, when the primary-side circuit 1A operates to cause the primary-side trace Tp1 to generate the first direction magnetic flux F_D1 and cause the magnetic flux to shift, the second direction magnetic flux F_D2 generated by the secondary-side trace Ts1 shifts the magnetomotive force MMF in the opposite direction. Therefore, the first direction magnetic flux F_D1 and the second direction magnetic flux F_D2 can be maintained within a specific range Rm formed by the magnetic flux origin M0 and the first predetermined offset Ml and the second predetermined offset Mr, so that the magnetomotive force MMF of the planar transformer 2A maintains balanced. As shown in FIG. 5A, the configuration of the stacked structure from the top to the bottom of the circuit board CB1 is the first trace Ts1_1, the primary-side trace Tp1, the second trace Ts1_2, the second trace Ts1_2, the primary-side trace Tp1, the first trace Ts1_1, the second trace Ts1_2, the primary-side trace Tp1, the first trace Ts1_1, the first trace Ts1_1, the primary-side trace Tp1, and the second trace Ts1_2.

Specifically, when the primary-side trace Tp1 generates the first direction magnetic flux F_D1 from the magnetic flux origin M0 to the first predetermined offset Ml or to the second predetermined offset Mr (taking the first direction magnetic flux F_D1 shifts to the right as an example), the magnetomotive force MMF will reach the second predetermined offset Mr. Therefore, by using a specific stacked structure of the transformer 2A, the secondary-side trace Ts1 adjacent to the primary-side trace Tp1 operates to generate the second direction magnetic flux F_D2 to offset the first direction magnetic flux F_D1, thereby adjusting the magnetomotive force MMF to the magnetic flux origin M0. On the contrary, when the secondary-side trace Ts1 generates the second direction magnetic flux F_D2 from the magnetic flux origin M0 to the first predetermined offset Ml or to the second predetermined offset Mr (taking the second direction magnetic flux F_D2 shifts to the left as an example), the magnetomotive force MMF will reach the first predetermined offset Mr. Therefore, by using a specific stacked structure of the transformer 2A, the primary-side trace Tp1 adjacent to the secondary-side trace Ts1 operates to generate the first direction magnetic flux F_D1 to offset the second direction magnetic flux F_D2, thereby adjusting the magnetomotive force MMF to the magnetic flux origin M0.

Since in the center-tapped structure of the first secondary-side coil 24A, only the rectification switch SR1 or the rectification switch SR2 operates in the same half cycle, when the path formed by the first trace Ts1_1 and the rectification switch SR1 (or a diode) of the secondary-side circuit 3A is forward biased, the magnetomotive force MMF will form a first magnetomotive force curve C1 as shown in FIG. 5A. On the contrary, when the path formed by the second trace Ts1_2 and the rectification switch SR2 (or a diode) of the secondary-side circuit 3A is forward biased, the magnetomotive force MMF will form a second magnetomotive force curve C2 as shown in FIG. 5B. In the first magnetomotive force curve C1 of FIG. 5A, since the rectification switch SR2 is turned off so that the second coil 24A-2 and the rectification switch SR2 do not form a current path, the magnetomotive force MMF of the second trace Ts1_2 is horizontally maintained. On the contrary, in the second magnetomotive force curve C2 of FIG. 5B, since the rectification switch SR1 is turned off so that the first coil 24A-1 and the rectification switch SR1 do not form a current path, the magnetomotive force MMF of the first trace Ts1_1 is horizontally maintained. Therefore, the present disclosure uses a specific stacked structure of the transformer 2A, so that the transformer 2A can maintain the balance of the magnetomotive force MMF under various operations, and the maximum magnetic flux is reduced by half (compared to the related art). Therefore, the AC eddy current losses can be reduced, efficiency can be increased, and line losses and leakage inductance can be effectively reduced under the corresponding large current.

On the other hand, since in the center-tapped structure of the first secondary-side coil 24A, only the rectification switch SR1 or the rectification switch SR2 operates in the same half cycle, when the path formed by the first trace Ts1_1 and the rectification switch SR1 (or a diode) of the secondary-side circuit 3A is forward biased, the "adjacent" refers to the first trace Ts1_1 closest to the primary-side trace Tp1, or the primary-side trace Tp1 closest to the first trace Ts1_1 in FIG. 5A. On the contrary, in FIG. 5B, the "adjacent" refers to the second trace Ts1_2 closest to the primary-side trace Tp1, or the primary-side trace Tp1 closest to the second trace Ts1_2.

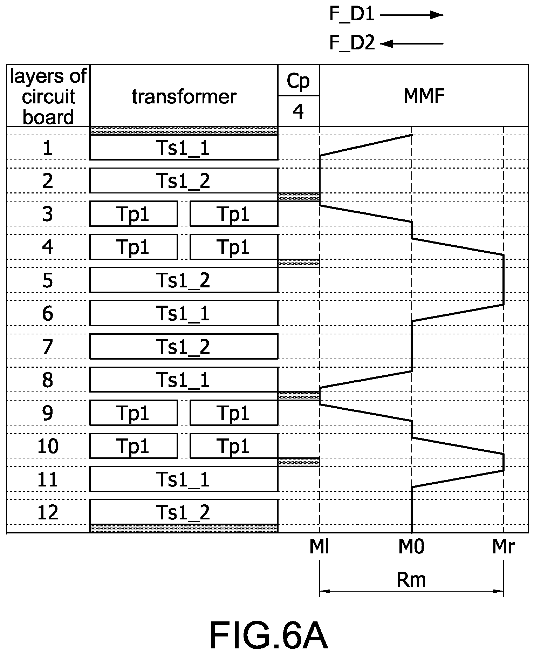

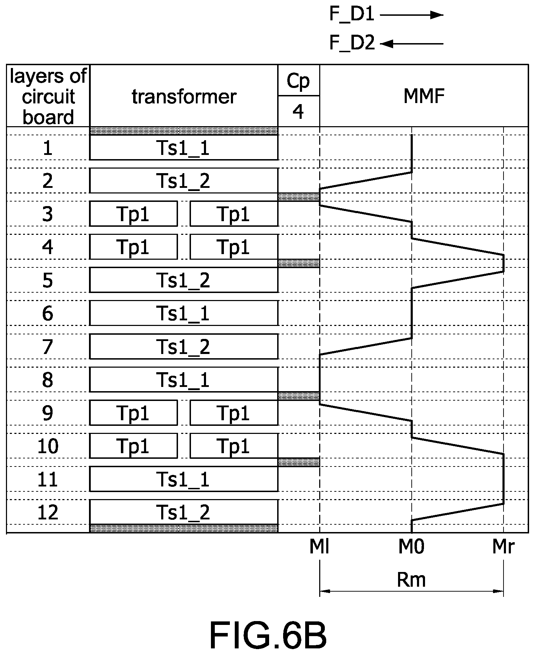

Please refer to FIG. 6A, which shows a stacked structure of the planar transformer on each layer of the circuit board according to the second embodiment of the present disclosure, and a magnetomotive force curve diagram when the planar transformer is operated on first traces; please refer to FIG. 6B, which shows a stacked structure of the planar transformer on each layer of the circuit board according to the second embodiment of the present disclosure, and the magnetomotive force curve diagram when the planar transformer is operated on second traces, and also refer to FIG. 2 to FIG. 5B. Although the stacked structure and magnetomotive force curve in FIG. 6A and FIG. 6B are different from those in FIG. 5A and FIG. 75B, they can achieve the same effect as FIG. 5A and FIG. 5B. Specifically, as shown in FIG. 6A, the configuration of the stacked structure from the top to the bottom of the circuit board CB1 is the first trace Ts1_1, the second trace Ts1_2, the primary-side trace Tp1, the primary-side trace Tp1, the second trace Ts1_2, the first trace Ts1_1, the second trace Ts1_2, the first trace Ts1_1, the primary-side trace Tp1, the primary-side trace Tp1, the first trace Ts1_1, and the second trace Ts1_2.

In FIG. 6A and FIG. 6B, when the primary-side circuit 1A operates to cause the primary-side trace Tp1 to generate the first direction magnetic flux F_D1 and cause the magnetic flux to shift, the second direction magnetic flux F_D2 generated by the secondary-side trace Ts1 shifts the magnetomotive force MMF in the opposite direction, and vice versa. In FIG. 5A, the layer between the primary-side trace Tp1 and the secondary-side trace Ts1 may form a sensing layer Cp. When the number of sensing layers Cp is greater, the coupling effect between the primary-side trace Tp1 and the secondary-side trace Ts1 is better (eight sensing layers Cp are shown in FIG. 5A). On the contrary, when the number of sensing layers Cp is smaller, the common mode noise will be smaller, so that the effect of suppressing electromagnetic interference is better (four sensing layers Cp are shown in FIG. 6A).

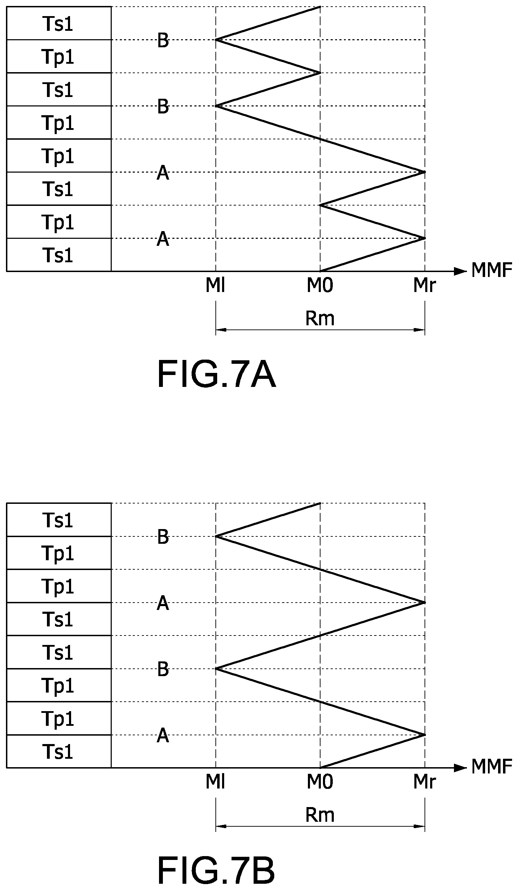

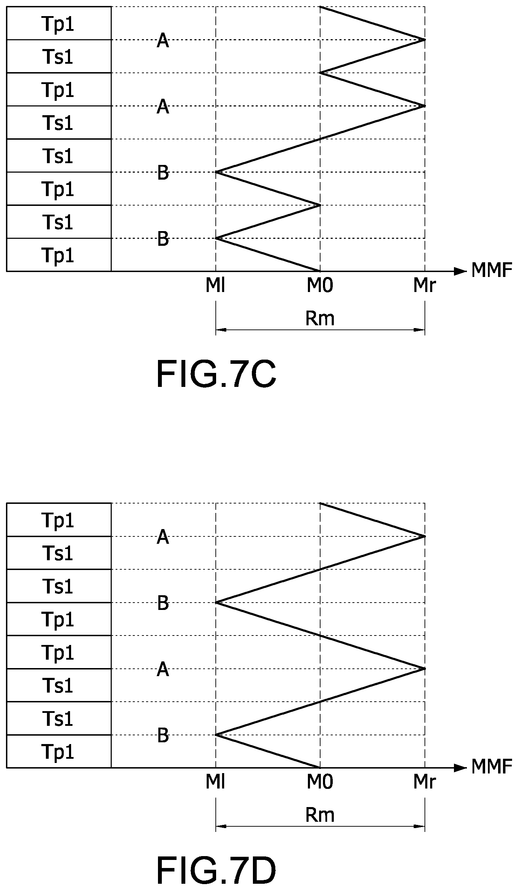

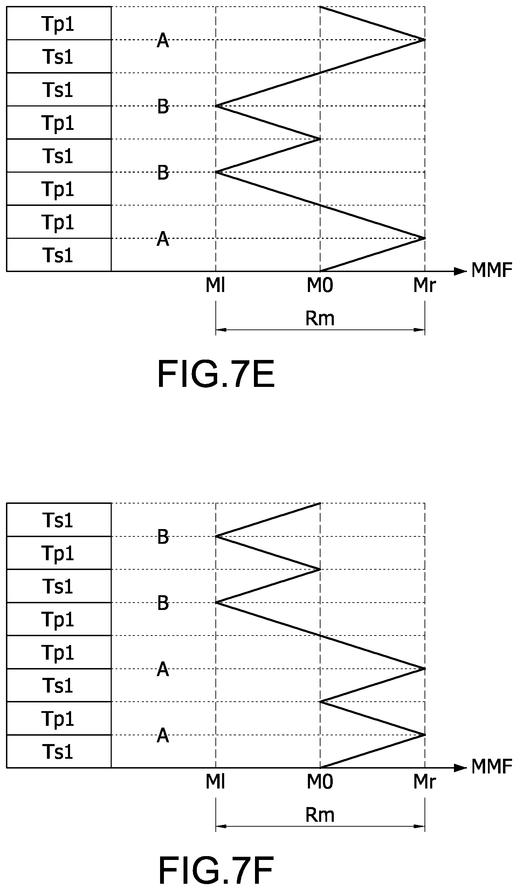

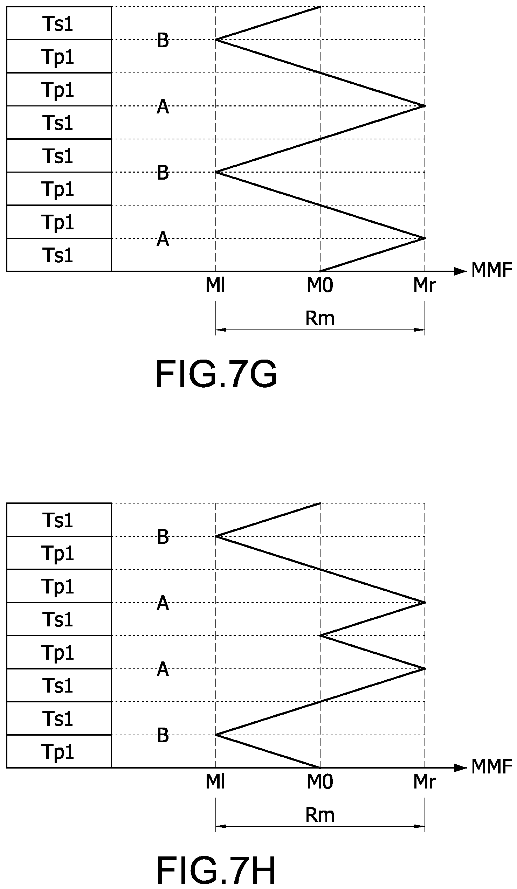

Please refer to FIG. 7A to FIG. 7H, which respectively show stacked structures and magnetomotive force curves on each layer of the circuit board of the planar first transformer according to the third to tenth embodiments of the present disclosure, and also refer to FIG. 2 to FIG. 6B. In FIG. 7A and FIG. 7H, the circuit board CB1 is a 12-layer board, and the secondary-side trace Ts1 includes the first trace Ts1_1 and the second trace Ts1_2 (the first trace Ts1_1 and the second trace Ts1_2 are simplified to only one layer). In particular, the stacked structure of the circuit board CB1 is shown in FIG. 7A and FIG. 7H and will not be described again here. Furthermore, the following commonalities can be summarized from the magnetomotive force curves shown in FIG. 5A to FIG. 7H:
1. After the magnetomotive force MMF shifts to one side, it will not shift in the same direction subsequently. The magnetomotive force MMF will definitely be pulled back to the magnetic flux origin M0 by the magnetic flux in the opposite direction (it is not excluded that it will first pass through the horizontal magnetic flux).
2. The number of times the magnetomotive force MMF reaches the first predetermined offset Ml is equal to the number of times it reaches the second predetermined offset Mr.
3. The number B of the (closed) waveforms of the triangle (or trapezoid) formed by the magnetomotive force MMF between the magnetic flux origin M0 and the first predetermined offset Ml is preferably equal to the number A of the (closed) waveform of the triangle (or trapezoid) formed by the magnetomotive force MMF between the magnetic flux origin M0 and the second predetermined offset Mr so as to provide good magnetic flux distribution (that is, the distribution to the left and right of the magnetic flux origin M0 is relatively even).
4. The magnetomotive force MMF starts from the magnetic flux origin M0 and finally returns to the magnetic flux origin M0 to achieve the effect of magnetic flux balance. The magnetomotive force MMF takes the magnetic flux origin M0 as the midpoint and presents a symmetrical and complementary curve on the left and right.

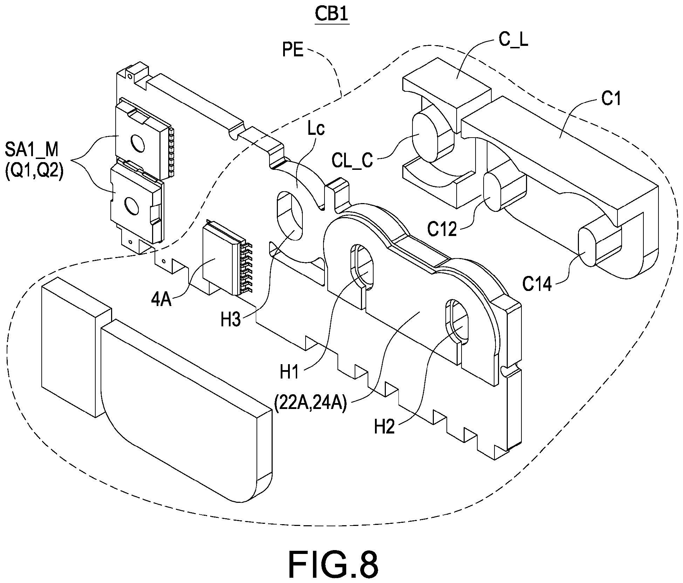

Please refer to FIG. 8, which a schematic structural diagram of the inductor core and the first iron core with the first through hole, the second through hole, and the third through hole of the present disclosure, and also refer to FIG. 1 to FIG. 7H. In FIG. 3A, the first core pillar C12 and the second core pillar C14 of the transformer 2A may both be circular pillars. However, since the magnetic field lines must complete the circuit in the shortest path, the circular cylinder (circular pillar) structure will cause the magnetic field lines to gather at a circular point, which may cause uneven distribution of the magnetic field. Therefore, in FIG. 8, the cylinder shapes of the first core pillar C12 and the second core pillar C14 of the transformer 2A can be changed to elliptical cylinders with straight sides. Moreover, the hole shapes of the first through hole H1 and the second through hole H2 may also be elliptical through holes for the first core pillar C12 and the second core pillar C14 to penetrate. Furthermore, since the adjacent sides of the two core pillars C12,C14 are substantially parallel straight lines, the shortest distances between them are the same, thereby increasing the magnetic field distribution between traces and increasing efficiency.

## Claims

1. A planar transformer (2A) arranged on a circuit board (CB1) of a resonant converter (100), the resonant converter (100) comprising a primary-side circuit (1A) and a secondary-side circuit (3A), **characterized in that** the planar transformer (2A) comprising:
a plurality of primary-side traces (Tp1) respectively formed on a plurality of primary-side layers on the circuit board (CB1); the primary-side traces (Tp1) serve as a primary-side coil (22A) coupled to the primary-side circuit (1A), so that when the primary-side circuit (1A) operates, the primary-side traces (Tp1) respectively generate a first direction magnetic flux (F_D1),
a plurality of secondary-side traces (Ts1) respectively formed on a plurality of secondary-side layers on the circuit board (CB1); the secondary-side traces (Ts1) serve as a secondary-side coil (24A) coupled to the secondary-side circuit (3A), so that when the secondary-side circuit (3A) operates, the secondary-side traces (Ts1) respectively generate a second direction magnetic flux (F_D2), and
an iron core (C1) comprising a first core pillar (C12) and a second core pillar (C14), the first core pillar (C12) and the second core pillar (C14) respectively penetrating a first through hole (H1) and a second through hole (H2) of the circuit board (CB1), and the primary-side traces (Tp1) and the secondary-side traces (Ts1) surrounding the first core pillar (C12) and the second core pillar (C14),
wherein the primary-side traces (Tp1) and the secondary-side traces (Ts1) are configured in a specific stacked structure to maintain the first direction magnetic flux (F_D1) and the second direction magnetic flux (F_D2) within a specific range (Rm) formed by a magnetic flux origin (M0) and a first predetermined offset (Ml) and a second predetermined offset (Mr), so that a magnetomotive force (MMF) of the planar transformer (2A) remains balanced.

2. The planar transformer (2A) as claimed in claim 1, wherein when one of the primary-side traces (Tp1) generates the first direction magnetic flux (F_D1) from the magnetic flux origin (M0) to the first predetermined offset (Ml) or the second predetermined offset (Mr), the second direction magnetic flux (F_D2) is generated by the operation of the secondary-side trace (Ts1) adjacent to the primary-side trace (Tp1) to adjust the magnetomotive force (MMF) to the magnetic flux origin (M0).

3. The planar transformer (2A) as claimed in claim 1, when one of the secondary-side traces (Ts1) generates the second direction magnetic flux (F_D2) from the magnetic flux origin (M0) to the first predetermined offset (Ml) or the second predetermined offset (Mr), the first direction magnetic flux (F_D1) is generated by the operation of the primary-side trace (Tp1) adjacent to the secondary-side trace (Ts1) to adjust the magnetomotive force (MMF) to the magnetic flux origin (M0).

4. The planar transformer (2A) as claimed in claim 1, wherein the number of times the magnetomotive force (MMF) reaches the first predetermined offset (Ml) is equal to the number of times the magnetomotive force (MMF) reaches the second predetermined offset (Mr).

5. The planar transformer (2A) as claimed in claim 1, wherein the number of first waveforms (B) formed by the magnetomotive force (MMF) between the magnetic flux origin (M0) and the first predetermined offset (Ml) is equal to the number of second waveforms (A) formed by the magnetomotive force (MMF) between the magnetic flux origin (M0) and the second predetermined offset (Mr).

6. The planar transformer (2A) as claimed in claim 1, wherein the secondary-side coil (24A) is a center-tapped coil, and the secondary-side traces (Ts1) respectively comprise first traces (Ts1_1) in a plurality of layers and second traces (Ts1_2) in a plurality of layers; when a path formed by the first traces (Ts1_1) and the secondary-side circuit (3A) is forward biased, the magnetomotive force (MMF) forms a first magnetomotive force curve (C1), and when a path formed by the second traces (Ts1_2) and the secondary-side circuit (3A) is forward biased, the magnetomotive force (MMF) forms a second magnetomotive force curve (C2).

7. The planar transformer (2A) as claimed in claim 6, wherein in the first magnetomotive force curve (C1), the magnetomotive force (MMF) of the second traces (Ts1_2) remain horizontal.

8. The planar transformer (2A) as claimed in claim 6, wherein in the second magnetomotive force curve (C2), the magnetomotive force (MMF) of the first traces (Ts1_1) remain horizontal.

9. The planar transformer (2A) as claimed in claim 6, wherein the configuration of the stacked structure from a top layer to a bottom layer of the circuit board (CB1) is sequentially the first trace (Ts1_1), the primary-side trace (Tp1), the second trace (Ts1_2), the second trace (Ts1_2), the primary-side trace (Tp1), the first trace (Ts1_1), the second trace (Ts1_2), the primary-side trace (Tp1), the first trace (Ts1_1), the first trace (Ts1_1), the primary-side trace (Tp1), and the second trace (Ts1_2).

10. The planar transformer (2A) as claimed in claim 6, wherein the configuration of the stacked structure from a top layer to a bottom layer of the circuit board (CB1) is sequentially the first trace (Ts1_1), the second trace (Ts1_2), the primary-side trace (Tp1), the primary-side trace (Tp1), the second trace (Ts1_2), the first trace (Ts1_1), the second trace (Ts1_2), the first trace (Ts1_1), the primary-side trace (Tp1), the primary-side trace (Tp1), the first trace (Ts1_1), and the second trace (Ts1_2).
